# DEMANDE DE BREVET EUROPEEN

(11) **EP 4 443 479 A1**
(43) Date de publication de la demande: **09.10.2024**
(21) Numéro de dépôt: 24165197.5
(22) Date de dépôt: 21.03.2024
(51) Int. Cl.: H01L 21/3105, H01L 23/29

(54) **PROCÉDÉ DE RECTIFICATION D'UN FILM POLYMÈRE**

(30) Priorité: 30.03.2023 FR 2303106
(71) Demandeur: Commissariat à l'Energie Atomique et aux Energies Alternatives, 75015 Paris (FR)
(72) Inventeur: MONTMEAT, Pierre, 38054 GRENOBLE Cedex 09 (FR); FOURNEL, Franck, 38054 GRENOBLE Cedex 09 (FR); ENOT, Thierry, 38054 GRENOBLE Cedex 09 (FR)
(74) Mandataire: Germain Maureau

(57) **Abrégé**

Procédé de rectification d'un film polymère (3) comprenant les étapes de :
a) fourniture d'un premier substrat (1) comprenant une surface avant (2), la surface avant (2) présentant une énergie de surface inférieure à environ 22 mJ/m²,
b) étalement d'un polymère thermoplastique sur la surface avant (2) conduisant à la formation d'un film polymère (3) et d'au moins une zone démouillée (8) de la surface avant (2),
c) fourniture d'un second substrat (4) comprenant une surface antiadhésive (5),
d) collage du film polymère (3) et de la surface antiadhésive (5) conduisant à la formation d'une interface de collage (7) présentant une énergie d'adhérence (Ea2) inférieure à l'énergie d'adhérence (Ea1) entre le film polymère (3) et la surface avant (2),
e) application d'un traitement de fluage de sorte que l'au moins une zone démouillée (8) de la surface avant (2) se couvre par fluage du film polymère (3), et
f) démontage à l'interface de collage (7) de sorte à obtenir la surface avant (2) totalement couverte par le film polymère (3) rectifié.

## Description

La présente invention se rapporte au domaine des structures en matériau semiconducteur pour la fabrication de composants électroniques. En particulier, l'invention concerne un procédé de rectification d'un film polymère sur une surface peu mouillante. Selon un autre aspect, l'invention propose une structure multicouche pouvant être obtenue par ledit procédé et une structure intermédiaire pouvant être obtenue au cours dudit procédé.

Les procédés de fabrication des composants électroniques utilisent souvent des polymères organiques sous forme de film mince. Le polymère peut être employé pour différentes applications :
- Il peut jouer le rôle d'adhésif permanent ou temporaire
- Il peut jouer un rôle d'isolant électrique
- Il peut protéger des composants en les encapsulant
- Il peut être utilisé comme résine de masquage lors d'une étape de photolithographie, etc...

Le polymère est généralement proposé en solution. Il est étalé en film mince sur un substrat comme une plaquette de silicium par enduction centrifuge. Le procédé d'étalement conduit à un film couvrant et homogène en épaisseur. Toutefois, si la surface sur laquelle il est étalé n'est pas suffisamment mouillante, par exemple une surface présentant une faible énergie de surface, le polymère démouille et on observe des zones de surface non couvertes. Cette structure rend impossible l'utilisation de la plaquette notamment pour les procédés ultérieurs susmentionnés.

Un des buts de la présente invention est de pallier au moins le problème de couvrement d'une surface peu mouillante par un film polymère. A cet effet, la présente invention propose un procédé de rectification d'un film polymère comprenant les étapes de :
a) fourniture d'un premier substrat comprenant une surface avant, la surface avant présentant une énergie de surface inférieure à environ 22mJ/m²,
b) étalement d'un polymère thermoplastique sur la surface avant conduisant à la formation d'un film polymère et d'au moins une zone démouillée de la surface avant,
c) fourniture d'un second substrat comprenant une surface antiadhésive,
d) collage du film polymère et de la surface antiadhésive conduisant à la formation d'une interface de collage présentant une énergie d'adhérence Ea2 inférieure à l'énergie d'adhérence Ea1 entre le film polymère et la surface avant,
e) application d'un traitement de fluage au film polymère de sorte que l'au moins une zone démouillée se couvre par le fluage du film polymère, et
f) démontage du second substrat et du premier substrat à l'interface de collage de sorte à obtenir la surface avant totalement couverte par le film polymère rectifié.

Ainsi, le procédé de l'invention utilise avantageusement la capacité à fluer des polymères thermoplastiques pour venir couvrir par fluage les zones démouillées de la surface avant peu mouillante. La surface avant est ainsi couverte en totalité par le film polymère à l'issu de l'étape e) ou f). Le film polymère obtenu est continu. Sa surface exposée présente une rugosité identique à celle de la surface du second substrat. Le fait de prévoir une surface antiadhésive sur le second substrat permet une adhésion de faible énergie Ea2, notamment par la présence de liaison de type Van der Waals, qui permet la tenue mécanique de l'ensemble collé à l'étape d) mais qui autorise le démontage de l'étape f).

Par le terme 'démouiller' et ses dérivés, on entend dans le présent document le sens utilisé en chimie physique qui traduit le fait qu'un film déposé sur une surface se retire spontanément d'une zone de ladite surface conduisant à réduire l'aire de contact entre la surface et le film.

Par l'expression `surface ou film antiadhésif, on entend une surface ou un film qui assure une faible adhérence avec un objet mis à son contact, typiquement une énergie d'adhérence inférieure ou égale à environ 1100 mJ/m², notamment une énergie d'adhérence inférieure ou égale à environ 1000 mJ/m² et par exemple une énergie d'adhérence inférieure ou égale à environ 900mJ/m².

Selon une possibilité, l'énergie d'adhérence Ea1 entre la surface avant et le film polymère et l'énergie d'adhérence Ea2 entre le film polymère et la surface antiadhésive respecte la condition suivante Ea1 > Ea2 + 100mJ/m² de sorte à pouvoir aisément démonter l'interface de collage à l'étape f) tout en conservant le film polymère sur le premier substrat, couvrant la totalité de la surface antiadhésive.

Selon une disposition, l'étape b) est réalisée par un dépôt par enduction centrifuge (méthode également connue sous l'expression anglo-saxonne 'spin coating') d'une formulation liquide comprenant le polymère thermoplastique sur la surface avant.

Selon une possibilité, l'étape b) comprend après le dépôt par enduction centrifuge au moins une étape d'application d'un traitement thermique d'évaporation d'un ou plusieurs solvants de la formulation liquide.

Selon une autre disposition, l'étape b) est réalisée par un dépôt par nébulisation (méthode également connue sous l'expression anglo-saxonne spray coating) d'une formulation liquide comprenant le polymère thermoplastique sur la surface avant.

Selon une variante, l'étape b) est réalisée par trempage d'au moins la surface avant dans une formulation liquide comprenant le polymère thermoplastique.

Selon une disposition, l'étape d) de collage conduit à la formation d'une structure intermédiaire comprenant le premier substrat collé au second substrat avec une énergie d'adhérence Ea1.

Selon une disposition, le traitement de fluage selon l'étape e) est obtenu par application d'un traitement thermique au film polymère, notamment pour obtenir une viscosité du film polymère inférieure à 10⁴ Pa.s. Cette viscosité permet au polymère de suffisamment fluer pour pouvoir s'étaler et couvrir de façon pérenne les zones démouillées de la surface avant du premier substrat. Une structure multicouche comprenant un film polymère rectifié couvrant la totalité de la surface avant du premier substrat est alors obtenu.

Selon une possibilité, le traitement thermique est réalisé à une température T supérieure à la température de transition vitreuse Tg du polymère thermoplastique, et notamment tel que T > Tg +100°C. Le respect de cette condition garanti d'atteindre la viscosité souhaitée du polymère. Il peut alors s'étaler pour venir couvrir la ou les zones démouillées de la surface avant.

Selon une disposition, le traitement de fluage selon l'étape e) est réalisé sous une pression (ou vide) de 0,01 Pa. Cette condition évite notamment la présence d'oxygène au cours de l'étape e) pouvant conduire à la dégradation du film polymère.

Selon un mode de réalisation particulier de l'invention, l'étape e) du traitement de fluage est complétée par l'application d'une compression sur le premier substrat collé au second substrat. Cette compression est de préférence appliquée selon une direction sensiblement perpendiculaire au plan de l'interface de collage, notamment avec une intensité comprise entre 0.02 et 2 MPa, plus spécifiquement entre 0,1 et 1MPa pour des premiers et seconds substrats de 200 ou 300 mm de diamètre.

Pratiquement, la compression peut être appliquée directement dans une machine de collage par thermocompression.

Concrètement, l'étape f) de démontage comprend l'application d'une contrainte mécanique à l'interface de collage entre le film polymère et la surface antiadhésive, telle que l'insertion d'un coin, d'une lame à l'interface, ou un jet de fluide, etc...

En variante, la contrainte mécanique est exercée par application d'une force de traction et/ou de cisaillement, ou de courbure à la structure obtenue à l'étape e).

Selon une disposition, la surface avant du premier substrat présente une topographie élevée, par exemple liée à la présence de piliers de quelques dixièmes de micromètres de diamètres sur une hauteur de quelques micromètres ou quelques dizaines de micromètres.

Selon une possibilité, le second substrat comprend une plaquette rigide et un film antiadhésif formant la surface antiadhésive.

Par plaquette rigide, on entend une plaquette qui présente les mêmes propriétés de rigidité que le premier substrat.

Concrètement, le matériau de la plaquette rigide est choisi parmi le silicium, le germanium, le verre, le saphir, le SiC, le GaAs, l'InP, le LNO ou le LTO.

Selon un exemple de réalisation le film antiadhésif est formé par dépôt sur la plaquette rigide.

Suivant une possibilité, le film antiadhésif est obtenu à partir de composés choisis parmi les organo-sylilés, tel que l'OTS fourni par Sigma Aldrich, les polymères fluorés, tel que le polymère 'Novec^{™} 1720 EGC' (pour Electronic Grade Coating) de 3M^{™}, l'Optool fourni par la société DAIKIN et le polymère 'Novec^{™} 2702 EGC' (pour Electronic Grade Coating) de 3M^{™}. L'un des composés est déposé par étalement à la tournette (ou Spin coating en terminologie anglo-saxonne) jusqu'à l'obtention d'un film antiadhésif présentant une épaisseur environ de 5 nanomètres sur la plaquette rigide.

Selon une réalisation particulière de l'invention, le film antiadhésif est obtenu en disposant une feuille de matériau antiadhésif sur ladite plaquette rigide, tel qu'une feuille de polyimide UPILEX-S ou de téflon/PTFE. Ladite feuille présente de préférence une épaisseur suffisante pour être autoportée, notamment quelques dizaines de micromètres. Par exemple la feuille de polyimide UPILEX-S ou de téflon/PTFE présente une épaisseur d'environ 50 micromètres
Selon cette disposition particulière l'étape f) comprend la séparation entre la plaquette rigide et le film polymère collé au premier substrat, puis le pelage de la feuille de matériau antiadhésif du film polymère.

Selon une possibilité, le second substrat est une plaque de téflon, présentant notamment une épaisseur de quelques dizaines de mm, de sorte garantir la résistance mécanique nécessaire à la réalisation de l'étape f) de démontage. Bien entendu, la plaque de téflon constitue à elle seule le second substrat et la surface antiadhésive.

Avantageusement, le procédé comprend avant l'étape b) une étape de détourage comprenant le retrait de matière à partir de la surface avant du premier substrat de sorte à former un évidement dans une région périphérique annulaire du premier substrat. L'évidemment permet de recevoir un éventuel débordement du polymère thermoplastique à l'étape e) de fluage.

Selon une disposition, la région périphérique annulaire s'étend le long du pourtour périphérique du premier substrat.

Selon une possibilité, l'évidemment présente une largeur L comprise entre environ 0,5 et 3 mm.

Selon une disposition, l'évidemment présente une hauteur H comprise entre 50 à 250 micromètres. Les dimensions de l'évidemment sont variables en fonction des risques de débordement du matériau thermoplastique à l'état de fluage, et donc de la quantité de matériau thermoplastique déposé à l'étape b). Si le débordement est contrôlé, la réalisation d'un détourage n'est pas nécessaire, sans compter que selon les cas, le débordement peut être géré par un nettoyage ultérieur.

De manière concrète, l'étape de détourage est simple à mettre en oeuvre et peut être réalisée à l'aide d'une scie diamantée de détourage ou une rodeuse. Cette méthode est peu coûteuse et permet d'obtenir une grande homogénéité dans le retrait de matière périphérique. La largeur L du détourage est obtenue avec une variation de seulement 10 microns et la hauteur H avec une variation de seulement 1 à 2 microns.

Selon une autre possibilité, le détourage de l'étape c) est effectué par une étape de photolithographie suivie d'une étape de gravure ionique ou de gravure chimique. Cette méthode permet une précision de l'homogénéité dans des dimensions de la largeur L et de la hauteur H inférieure à 1 micromètre.

Selon une variante de réalisation l'étape e) de traitement de fluage est concomitante à l'étape d) de collage entre le film polymère et la surface antiadhésive.

Selon une autre possibilité, le procédé comprend en outre après l'étape f)
- une étape g) de mise en contact du film polymère, recouvrant la surface avant du premier substrat, avec une face avant d'un troisième substrat de sorte à obtenir un collage avec une énergie d'adhérence Ea3,
- une étape technologique h) réalisée sur une face arrière du troisième substrat, opposée à la face avant, notamment un amincissement par rodage suivi d'un polissage mécano-chimique, et
- une étape de démontage i) du premier substrat présentant une énergie d'adhérence avec le film polymère Ea1 < Ea3, de sorte à récupérer le troisième substrat.

Le collage du film polymère avec le troisième substrat est un collage fort, présentant une énergie d'adhérence Ea3 élevée, et dans tous les cas, supérieure à Ea1.

Ce procédé est notamment avantageux dans le cas où il n'est pas possible d'étaler le film polymère sur le troisième substrat.

Selon un deuxième aspect, l'invention propose une structure multicouche comprenant un film polymère couvrant la totalité d'une surface avant d'un premier substrat, la surface avant présentant une énergie de surface inférieure à environ 22 mJ/m². Cette structure multicouche permet la réalisation de nombreuses étapes ultérieures de procédé notamment dans le domaine de la fabrication de composants électroniques.

De préférence, le film polymère est en polymère thermoplastique.

Selon d'autres caractéristiques, l'invention comporte une ou plusieurs des caractéristiques optionnelles suivantes considérées seules ou en combinaison :
- L'énergie d'adhérence Ea1 entre le film polymère et la surface avant est inférieure à 0,9 J/m² et notamment inférieure à 0,5 J/m² et par exemple d'environ 0,2 J/m².
- La surface avant du premier substrat présente une énergie de surface inférieure à environ 20mJ/m², notamment inférieure à environ 18mJ/m² et par exemple inférieure à environ 16mJ/m².
- L'énergie d'adhérence Ea2 entre le film polymère et la surface antiadhésive est comprise entre environ 0,05 J/m² et 0 ,1 J/m².
- Le film polymère présente une épaisseur comprise entre 15 et 120 micromètres.
- La surface avant comprend une topographie élevée, telle qu'une surface structurée, et/ou présentant une basse énergie de surface.
- Le premier substrat est en matériau semiconducteur tel que le silicium, le germanium, le verre, le saphir, le SiC, le GaAs, l'InP, le LNO ou le LTO.
- Le polymère thermoplastique est choisi parmi le BrewerBOND^{®} 305 disponible auprès du fournisseur Brewer Science, le TWM12000 disponible auprès du fournisseur TOK et un polymère dont la viscosité est inférieure à 10⁴ Pa.s à partir d'une température déterminée.
- La surface avant du premier substrat présente une structuration consistant en des piliers d'une hauteur comprise entre 3 et 10 micromètres.
- L'étape de détourage est effectuée avant ou après l'étape de structuration de la surface avant.
- Les piliers présentent notamment une section transversale de forme globalement carrée.
- Les dimensions de la section transversale sont comprises entre 3 et 8 micromètres.
- La surface avant présente une structuration comprenant des piliers de 5 micromètres de coté sur une hauteur de 5 micromètres avec un espacement inter-pilier de 10 micromètres.
- A l'issue de l'étape f) le film polymère s'étend au moins sur la totalité de la surface supérieure de tous les piliers de la surface avant.
- A l'issue de l'étape f), les côtés latéraux et la surface de fond des tranchées délimitées par les piliers sont partiellement recouverts de polymère.
- La surface avant du premier substrat présentant une énergie de surface inférieure à 22 mJ/m² est constituée par une couche déposée sur un substrat.
- Le film antiadhésif formant la surface antiadhésive du second substrat présente une épaisseur comprise entre 1 et 10 nanomètres.

Selon encore un autre aspect, la présente invention propose une structure intermédiaire comprenant la structure multicouche telle que précédemment décrite et un second substrat, le film polymère étant collé à une surface antiadhésive du second substrat avec une énergie d'adhérence Ea2 inférieure à l'énergie d'adhérence Ea1 entre le film polymère et la surface avant du premier substrat, et notamment Ea1 > Ea2 +100 mJ/m².

D'autres aspects, buts et avantages de la présente invention apparaîtront mieux à la lecture de la description suivante des différentes variantes de réalisation de celle-ci, données à titre d'exemple non limitatif et fait en référence aux dessins annexés. Les figures ne respectent pas nécessairement l'échelle de tous les éléments représentés de sorte à améliorer leur lisibilité. Dans la suite de la description, par souci de simplification, des éléments identiques, similaires ou équivalents des différentes formes de réalisation portent les mêmes références numériques. Par ailleurs, toutes les énergies d'adhérence décrites dans ce document sont déterminées par la technique du double levier à déplacement imposé (méthode d'insertion de coin ou méthode de Maszara, bien connues de l'homme de l'art). Les figures annexées sont :
Figure 1 illustre les étapes a) et b) du procédé selon un mode de réalisation de l'invention.
Figure 2 illustre les étapes c) à e) du procédé selon le mode de réalisation de la figure 1.
Figure 3 illustre l'étape f) du procédé selon le mode de réalisation de la figure 2.
Figure 4 illustre l'étape a) et l'étape de détourage du procédé selon un deuxième mode de réalisation de l'invention.
Figure 5 illustre les étapes b) à e) du procédé selon un deuxième mode de réalisation de l'invention.
Figure 6 illustre l'étape f) du procédé selon le deuxième mode de réalisation de l'invention.
Figure 7 illustre une structure multicouche dans lequel la surface avant est structurée selon un autre mode de réalisation de l'invention.

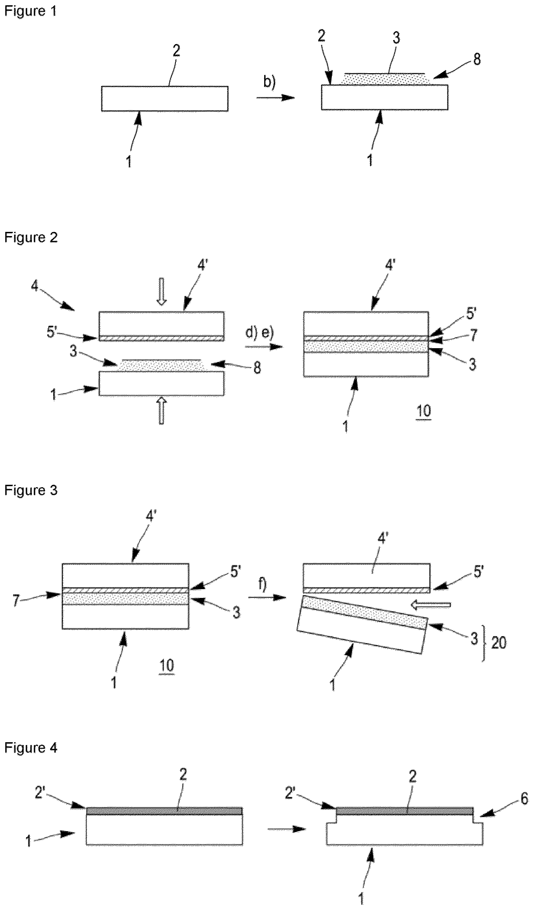

Les figures 1 à 3 illustrent le principe du procédé de rectification selon l'invention qui permet de recouvrir la totalité d'une surface à caractère antiadhésif ou peu mouillant d'un premier substrat (énergie de surface inférieure à environ 22 mJ/m²) par un film polymère à partir d'une formulation liquide d'un polymère thermoplastique.

En référence à la figure 1, un premier substrat 1 dont la surface avant 2 est peu mouillante est fourni (étape a), son énergie de surface est inférieure à 20 mJ/m². Une formulation liquide d'un film polymère 3 constitué d'un polymère thermoplastique est déposée par enduction centrifuge sur la surface avant 2 (étape b - énergie d'adhérence Ea1). Si nécessaire, des traitements thermiques sont réalisés de façon à évacuer les solvants de la formulation liquide après dépôt. Un démouillage du film polymère 3 est observé, il conduit à la formation d'une ou plusieurs zones démouillées 8 de la surface avant 2.

La figure 2 illustre la fourniture selon l'étape c) d'un second substrat 4 présentant une surface antiadhésive 5. Comme on peut le voir dans ce mode de réalisation particulier, le second substrat 4 est formé d'une plaquette rigide 4' et d'un film antiadhésif 5' disposé en surface, celui-ci formant la surface antiadhésive 5. Puis selon l'étape d), le film polymère 3 est collé au film antiadhésif 5' pour former une structure intermédiaire 10, le film antiadhésif 5' étant choisi de sorte que l'énergie d'adhérence Ea1 entre le film polymère 3 et le premier substrat 1 est supérieure à l'énergie d'adhérence Ea2 entre le film polymère 3 et le film antiadhésif 5'. Typiquement, l'énergie d'adhérence Ea1 est au moins supérieure à Ea2 + 0,1 J /m².

Une étape e) d'application d'un traitement de fluage est ensuite réalisée par thermocompression. Pour ce faire, une compression et une température suffisamment élevées sont appliquées à la structure intermédiaire 10. La température T de l'étape de thermocompression est notamment bien supérieure à la température de transition vitreuse Tg du polymère thermoplastique (T> Tg + 100°C). Dans ces conditions, le film polymère 3 devient fluide, il flue et vient combler les zones démouillées 8 de la surface avant 2, le fluage et le comblement des zones démouillées étant garanti lorsque la viscosité du polymère 3 est inférieure à 10⁴ Pa.s.

Comme illustré à la figure 3, l'application d'une contrainte mécanique, telle que l'insertion d'un coin dans la structure intermédiaire 10 collée, permet de démonter l'interface de collage 7 qui présente la plus faible énergie d'adhérence Ea2 à savoir l'interface entre le film polymère 3 et la surface antiadhésive 5 du second substrat 4. Ainsi, le procédé de l'invention permet de rectifier le film polymère 3 sur une surface avant 2 peu mouillante et d'obtenir d'une structure multicouche 20 pouvant être utilisée dans des étapes ultérieures de fabrication de composants électroniques.

Selon une possibilité non illustrée, en remplacement du film antiadhésif 5' disposée sur la plaquette rigide 4', une feuille antiadhésive (ex : une feuille de polyimide UPILEX-S) est insérée entre la surface du film polymère 3 et la plaquette rigide 4'.

Selon encore une autre variante non illustrée, le second substrat 4 est une plaque de téflon qui présente intrinsèquement une surface antiadhésive 5.

### Exemples de réalisation détaillés

Les exemples suivants sont réalisés au moyen de substrats 1,4 de silicium de 300 mm de diamètre.

### Exemple 1 :

Selon une possibilité illustrée à la figure 4, le premier substrat 1 est détouré à l'aide d'une scie diamantée de sorte à former un évidement 6 en région périphérique annulaire de la surface avant 2 sur une largeur L de 1,5 mm et une profondeur (ou hauteur H) de 200 µm. Puis une couche 2' fluorée en Novec^{™} 1720 est déposée sur un premier substrat 1 de silicium de sorte à former la surface avant 2 peu mouillante (figure 4).

Un polymère thermoplastique de BrewerBOND^{®} 305 est ensuite étalé avec une épaisseur de 40 µm sur la surface avant 2 de sorte à former le film polymère 3. Un démouillage du polymère 3 est observé. L'énergie d'adhérence Ea1 entre le film polymères en BrewerBOND^{®} 305 et la surface avant 2 en Novec^{™} 1720 est de 0,2 J/m².

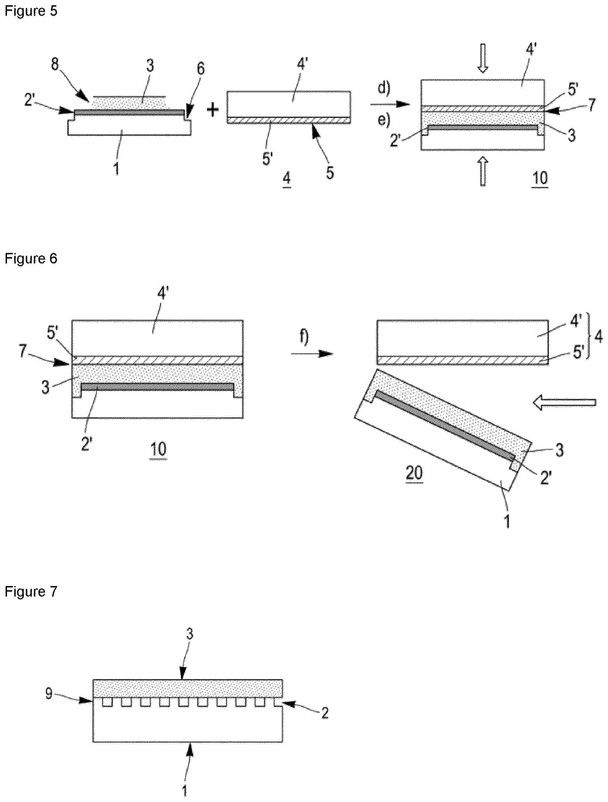

Sur une plaquette rigide 4' de silicium est déposée un film antiadhésif 5' d'octadécyltrichlorosilane (OTS) à partir d'une solution d'OTS dans l'isooctane conduisant à l'obtention du second substrat 4 et sa surface antiadhésive 5 (figure 5). Une fois mis en contact selon l'étape d), l'énergie d'adhérence Ea2 entre le film polymère 3 en BrewerBOND^{®} 305 et le surface antiadhésive 5 en OTS est de 0,07 J/m². Les premier et second substrat 1,4 sont ensuite placés à une température de 250°C, sous une compression de 0,28 MPa, une pression (ou un vide) de 0,01 Pa pendant une durée de 20 min (étapes d) et e). Ces conditions entrainent le fluage du film polymère 3 en BrewerBOND^{®} 305, ce qui comble les zones démouillées 8 de la surface avant 2 (étape e). La structure intermédiaire 10 ainsi obtenue est ensuite démontée à l'interface de collage 7 entre le film polymère 3 de BrewerBOND^{®} 305 et la surface antiadhésive 5 fluorée par insertion d'un coin (figure 6). La structure multicouche 20 finale est obtenue : le film polymère 3 en BrewerBOND^{®} 305 est rectifié, il recouvre la totalité de la surface avant 2 du premier substrat 1.

### Exemple 2 :

Selon une variante de réalisation non illustrée, une couche 2' fluorée en Novec^{™} 1720 est déposée sur un premier substrat 1 de silicium de sorte à former une surface avant 2 peu mouillante. Le premier substrat 1 est ensuite détouré à la scie diamantée pour former un évidement 6 sur une largeur de 2 mm et une profondeur de 100 µm.

Un polymère thermoplastique de BrewerBOND^{®} 305 est ensuite déposé pour former un film polymère 3 avec une épaisseur de 20 µm sur la surface avant 2 peu mouillante (étape b). On observe un démouillage du film polymère 3. L'énergie d'adhérence Ea1 entre le film polymère 3 en BrewerBOND^{®} 305 et la surface avant 2 en Novec^{™} 1720 est de 0,2 J/m².

On vient coller le premier substrat 1 avec une plaquette rigide 4' de silicium sur laquelle est disposée une feuille 5' de polyimide UPILEX-S de 50 µm, qui joue le rôle de surface antiadhésive 5 entre les deux substrats 1,4 (étape d). Le traitement de fluage (étape e) est réalisé par application d'une température de 250°C, avec une compression de 0.28 MPa, un vide de 0,01 Pa sur une durée de 20 min. Ces conditions entrainent le fluage du film polymère 3 qui vient combler les zones démouillées 8 de la surface avant 2 (étape e). L'énergie d'adhérence Ea2 entre le film polymère 3 et la feuille 5' d'UPILEX-S est très faible, par exemple < 0,05 J/m². On insère un coin dans la structure intermédiaire 10 pour démonter la plaquette rigide 4' puis la feuille d'UPILEX-S est pelée de la surface du film polymère 3. La structure multicouche 20 obtenue comporte le film polymère 3 rectifié, recouvrant la totalité de la surface avant 2 (en Novec^{™} 1720) du premier substrat 1.

Selon une autre variante non illustrée, une feuille de téflon/PTFE de quelques dizaines de micromètres est utilisée en lieu et la place de la feuille UPILEX-S.

Selon une alternative, une seule plaque de téflon de quelques dizaines de millimètres d'épaisseur est utilisée en remplacement du second substrat 4 ou de la plaquette rigide 4' et de la feuille antiadhésive 5'.

Selon encore une autre alternative, une presse à tête teflonnée est utilisée en lieu et place du second substrat présentant une surface antiadhésive (non illustrée). Cette presse teflonnée est également utilisée pour appliquer le traitement de compression. Dans cet exemple de réalisation, le premier substrat sera avantageusement maintenu en place, notamment par une table aspirante, lors de la remontée de tête. Cette variante permet avantageusement de réaliser la rectification sur plusieurs substrats de façon concomitante.

### Exemple 3 :

Selon encore une variante de réalisation non illustrée, un premier substrat 1 de silicium est détouré à la scie diamantée pour former un évidement 6 d'une largeur de 3 mm et d'une profondeur de 250 µm.

Une couche 2' de perfluorodecyltrichlorosilane (FDTS : Cl3Si(CH2)2(CF2)7CF3) est déposé sur le premier substrat 1 détouré, afin de créer la surface avant 2 peu mouillante. Un film polymère 3 en TWM12000 de 100 µm est ensuite déposé sur la surface avant 2 (étape b). On observe un démouillage du film en polymère thermoplastique 3. L'énergie d'adhérence Ea1 entre le film polymère 3 en TWM12000 et la surface avant 2 en FDTS est de 0,9 J/m².

Une plaquette 4' de silicium est en parallèle recouverte d'un film antiadhésif 5' d'Optool de sorte à fournir le second substrat 4. La mise en contact avec le film polymère 3 conduit l'obtention de la structure intermédiaire 10 et une énergie d'adhérence Ea2 inférieure à 0,1 J/m².

Le traitement de fluage est ensuite réalisé en appliquant un traitement thermique à une température de 240°C avec une compression de 0.23 MPa, sous un vide de 0,01 Pa pendant une durée de 20 min. Ces conditions entrainent le fluage du film polymère 3 en thermoplastique qui vient combler les zones démouillées 8 de la surface avant 2 (étape e). On insère un coin dans la structure 10 et le second substrat 4 est démonté, la structure multicouche 20 finale comportant le polymère 3 rectifié, recouvrant la totalité de la surface avant 2 est obtenue (étape f).

### Exemple 4 :

Selon une variante de réalisation illustrée à la figure 7, le procédé comprend avant l'étape a) une étape de photolithographie/gravure de la surface avant 2 du premier substrat 1 de silicium de sorte à structurer la surface 2 par création de piliers 9 de dimensions latérales de 5 micromètres sur 5 micromètres et d'une hauteur de 5 micromètres également, conduisant de facto à une surface avant 2 peu mouillante. L'étape b) consiste à déposer un polymère thermoplastique de BrewerBOND^{®} 305 pour former un film polymère 3 de 20 micromètres d'épaisseur, ce qui conduit à une zone démouillée 8 sur la surface avant.

Un second substrat 4 est fourni. Il comprend une plaquette rigide 4' de silicium recouverte par un film fluoré antiadhésif 5' de Novec^{™} 1720 qui forme la surface antiadhésive 5 (étape c). Le film polymère 3 est mis en contact avec la surface antiadhésive 5 puis le traitement de fluage est appliqué en effectuant un traitement thermique à 250°C accompagné d'une compression de 0,28 MPa sous un vide de 0,01 Pa pendant une durée de 20 minutes (étape d) et e)). Le fluage du film polymère 3 en thermoplastique permet de combler les zones démouillées 8 de la surface avant 2 (étape e). L'insertion d'un coin à l'interface 7 entre le film polymère 3 et la surface antiadhésive 5 permet le démontage du second substrat 4 et l'obtention de la structure multicouche 20 dans laquelle le film polymère 3 rectifié en BrewerBOND^{®} 305 recouvre la totalité de la surface avant 2 structurée du premier substrat 1, comme illustré sur la figure 7.

Egalement illustré, l'évidement obtenu par détourage du premier substrat 1 fait office de réservoir pour le polymère thermoplastique qui flue. Ceci permet d'éviter son débordement de la structure multicouche 20. Comme on l'a vu précédemment, cette étape de détourage peut être omise s'il n'y pas de risque de débordement (en cas par exemple d'une très fine couche de film polymère 3) ou si le débordement peut être géré par un nettoyage à postériori.

Selon un autre aspect non illustré sur les figures, le film polymère 3 recouvrant la surface avant 2 du premier substrat 1 obtenu à l'étape f) est mis en contact selon une étape g) avec une face avant d'un troisième substrat pour un collage fort, présentant une énergie d'adhérence Ea3 > Ea1. Des étapes de réalisation de circuits électroniques h) peuvent ainsi être appliquées sur le troisième substrat, tel qu'un amincissement par polissage mécanochimique CMP, un dépôt, une photolithographie ...etc. grâce à la présence du premier substrat 1 qui sert de poignée. Puis le premier substrat 1 présentant une faible adhérence avec le film polymère 3 est démonté (étape i) de sorte à récupérer le troisième substrat. Ceci est notamment avantageux dans le cas où il n'est pas possible d'étaler le film polymère 3 sur le troisième substrat.

Ainsi, la présente invention propose un procédé simple à mettre en oeuvre et permettant de rectifier un film polymère 3 sur une surface 2 peu mouillante d'un substrat 1 qui pourra être utilisé dans un grand nombre d'étapes ultérieures pour la fabrication de composés électroniques.

## Revendications

1. Procédé de rectification d'un film polymère (3) comprenant les étapes de :
a) fourniture d'un premier substrat (1) comprenant une surface avant (2), la surface avant (2) présentant une énergie de surface inférieure à environ 22 mJ/m²,
b) étalement d'un polymère thermoplastique sur la surface avant (2) conduisant à la formation d'un film polymère (3) et d'au moins une zone démouillée (8) de la surface avant (2),
c) fourniture d'un second substrat (4) comprenant une surface antiadhésive (5),
d) collage du film polymère (3) et de la surface antiadhésive (5) conduisant à la formation d'une interface de collage (7) présentant une énergie d'adhérence (Ea2) inférieure à l'énergie d'adhérence (Ea1) entre le film polymère (3) et la surface avant (2),
e) application d'un traitement de fluage au film polymère (3) de sorte que l'au moins une zone démouillée (8) de la surface avant (2) se couvre par le fluage du film polymère (3), et
f) démontage du second substrat (4) et du premier substrat (1) à l'interface de collage (7) de sorte à obtenir la surface avant (2) totalement couverte par le film polymère (3) rectifié.

2. Procédé de rectification d'un film polymère (3) selon la revendication 1, dans lequel le traitement de fluage selon l'étape e) est obtenu par application d'un traitement thermique au film polymère (3) de sorte que le film polymère (3) atteint une viscosité inférieure à 10⁴ Pa.s.

3. Procédé de rectification d'un film polymère (3) selon l'une des revendications 1 à 2, dans lequel l'étape e) du traitement de fluage est complétée par application d'une compression sur le premier substrat (1) collé au second substrat (4).

4. Procédé de rectification d'un film polymère (3) selon l'une des revendications 1 à 3, dans lequel l'étape f) de démontage comprend l'application d'une contrainte mécanique à l'interface de collage (7) entre le film polymère (3) et la surface antiadhésive (5).

5. Procédé de rectification d'un film polymère (3) selon l'une des revendications 1 à 4, dans lequel le second substrat (4) comprend une plaquette rigide (4') et un film antiadhésif (5'), le film antiadhésif (5') formant la surface antiadhésive (5).

6. Procédé de rectification d'un film polymère (3) selon la revendication 5, dans lequel le film antiadhésif (5') est obtenu en disposant une feuille de matériau antiadhésif sur ladite plaquette rigide (4'), tel qu'une feuille de polyimide UPILEX-S ou de téflon/PTFE.

7. Procédé de rectification d'un film polymère 3 selon l'une des revendications 1 à 4, dans lequel le second substrat (4) est une plaque de téflon.

8. Procédé de rectification d'un film polymère (3) selon l'une des revendications 1 à 7, lequel comprend avant l'étape b) une étape de détourage comprenant le retrait de matière à partir de la surface avant (2) du premier substrat (1) de sorte à former un évidement (6) dans une région périphérique annulaire du premier substrat (1).

9. Structure multicouche (20) comprenant un film polymère (3) thermoplastique rectifié couvrant la totalité d'une surface avant (2) d'un premier substrat (1) en matériau semiconducteur, la surface avant (2) présentant une énergie de surface inférieure à environ 22 mJ/m².

10. Structure intermédiaire (10) comprenant la structure multicouche (20) selon la revendication 9 et un second substrat (4), le film polymère (3) étant collé à une surface antiadhésive (5) du second substrat (4) avec une énergie d'adhérence (Ea2) inférieure à l'énergie d'adhérence (Ea1) entre le film polymère (3) et la surface avant (2) du premier (1).
